# EUROPEAN PATENT APPLICATION

(11) **EP 3 136 425 A1**
(43) Date of publication of application: **01.03.2017**
(21) Application number: 14859343.7
(22) Date of filing: 29.08.2014
(51) Int. Cl.: H01L 21/324, H01L 21/02

(54) **ELECTRIC HEATER TYPE WASTE GAS TREATMENT DEVICE AND ELECTRIC HEATER STRUCTURE USED THEREIN**

(30) Priority: 25.04.2014 KR 20140049771
(71) Applicant: Kim, Hyoung Suk, Siheung-si, Gyeonggi-do 429-777 (KR)
(72) Inventor: Kim, Hyoung Suk, Siheung-si, Gyeonggi-do 429-777 (KR)
(74) Representative: ABG Patentes, S.L.
(86) International application number: PCT/KR2014/008087
(87) International publication number: WO 2015/163540

(57) **Abstract**

Disclosed are an electric heater type harm-removing apparatus and an electric heater structure used in the same. The electric heater type harm-removing apparatus includes: a reaction chamber which has an electric heater structure installed therein, and is configured to receive waste gas supplied from an outside thereof, wherein the electric heater structure includes a porous metal structure. According to the present invention, it is possible to more activate the thermal decomposition of waste gas by maximizing the contact area between the electric heater structure and waste gas to more rapidly transfer heat from the heater to the waste gas with a uniform temperature distribution.

## Description

### [Technical Field]

The present invention relates to an electric heater type harm-removing apparatus and an electric heater structure used in the same, and more particularly, to an electric heater type harm-removing apparatus capable of more activating thermal decomposition by maximizing a contact area between the electric heater structure and waste gas to more rapidly and uniformly transfer heat from the electric heater structure to the waste gas to be thermally decomposed, and an electric heater structure used in the same.

### [Background Art]

An electric heater type harm-removing apparatus of the related art includes a reaction chamber having a bar-shaped or a wire-shaped electric heater provided therein, and is operated in such a manner that, by a contact reaction between waste gas including a perfluorocarbon compound (PFC) which is supplied from an outside of the reaction chamber and generated during a semiconductor manufacturing process and the electric heater, or by a heat transfer therebetween, the waste gas is thermally decomposed.

Meanwhile, according to the electric heater type harm-removing apparatus of the related art, a structure of the electric heater included in the electric heater type harm-removing apparatus is simplified in a bar shape or a wire shape. Thus, the contact area between the electric heater and the waste gas cannot but be relatively small. Therefore, it takes much time to transfer heat from the heater to the waste gas which does not pass through the vicinity of the electric heater structure but passes through a point slightly separated from the structure of the electric heater, and the heater structure needs to be maintained at a higher temperature than the temperature required for the thermal decomposition to achieve a sufficient heat transfer, such that uniformity of temperature distribution inside a reaction furnace may be deteriorated, and thereby harm-removing efficiency of the waste gas may be reduced.

### [Disclosure]

### [Technical Problem]

Accordingly, it is an object of the present invention to provide an electric heater type harm-removing apparatus capable of more activating thermal decomposition by maximizing a contact area between the electric heater structure and waste gas to more rapidly transfer heat from the heater to the waste gas with a uniform temperature distribution, and an electric heater structure used in the same.

### [Technical Solution]

In order to achieve the above-described objects, an electric heater type harm-removing apparatus according to the present invention may include: a reaction chamber which has an electric heater structure installed therein, and is configured to receive waste gas supplied from an outside thereof, wherein the electric heater structure may include a porous metal structure.

In addition, an electric heater type harm-removing apparatus according to the present invention may include: a reaction chamber which has an electric heater structure installed therein, and is configured to receive waste gas supplied from an outside thereof, wherein the electric heater structure may include an insulating base layer, and a band-shaped porous metal heater attached to one surface of the insulating base layer.

Preferably, the insulating base layer and the band-shaped porous metal heater may have flexibility.

Further, the insulating base layer may be formed in a spiral structure.

Further, the porous metal heater may be exposed to the waste gas supplied and flowed through the insulating base layer having the spiral structure.

Meanwhile, an electric heater type harm-removing apparatus according to the present invention may include: a reaction chamber which has an electric heater structure installed therein, and is configured to receive waste gas supplied from an outside thereof, wherein the electric heater structure may include a cylindrical case of which the upper part is opened, and a plurality of metal balls filled in the cylindrical case.

Preferably, an inner surface of the cylindrical case may be provided with an electrode part which is configured to supply a current to the metal balls contacting the inner surface of the cylindrical case.

Further, the plurality of metal balls are electrically connected to each other through a point contact with the adjacent metal balls.

Meanwhile, an electric heater structure installed inside an electric heater type harm-removing apparatus according to the present invention may include: an insulating base layer; and a band-shaped porous metal heater which is attached to one surface of the insulating base layer.

Preferably, the insulating base layer and the band-shaped porous metal heater may have flexibility.

Further, the insulating base layer may be formed in a spiral structure.

Further, the porous metal heater may be exposed to the waste gas supplied and flowed through the insulating base layer having the spiral structure.

Meanwhile, an electric heater structure installed inside an electric heater type harm-removing apparatus according to the present invention may include: a cylindrical case which is configured to receive waste gas from an opened upper part thereof; and a plurality of metal balls which are filled in the cylindrical case.

Preferably, an inner surface of the cylindrical case may be provided with an electrode part which is configured to supply a current to the metal balls contacting the inner surface of the cylindrical case.

Further, the plurality of metal balls are electrically connected to each other through a point contact with the adjacent metal balls.

### [Advantageous Effects]

According to the present invention, it is possible to more activate the thermal decomposition of waste gas by maximizing the contact area between the electric heater structure and the waste gas to more rapidly transfer heat from the electric heater to the waste gas with a uniform temperature distribution.

### [Description of Drawings]

FIG. 1 is a view illustrating a structure of an electric heater type harm-removing apparatus according to an embodiment of the present invention.
FIG. 2 is a photograph describing an electric heater structure included in the electric heater type harm-removing apparatus according to the embodiment of the present invention.
FIGS. 3 to 5 are views describing a modified structure of the electric heater structure included in the electric heater type harm-removing apparatus according to the embodiment of the present invention.
FIG. 6 is a view illustrating a structural modification process during manufacturing the electric heater structure of FIG. 3.
FIG. 7 is a view illustrating a structure of a reaction chamber into which the electric heater structure manufactured according to the method of FIG. 6 is inserted.
FIG. 8 is a view illustrating a state in which the electric heater structure manufactured according to the method of FIG. 6 is installed in the reaction chamber.
FIGS. 9 and 10 are views describing another modified structure of the electric heater structure included in the electric heater type harm-removing apparatus according to the embodiment of the present invention.

### [Best Mode]

Hereinafter, the present invention will be described with reference to the accompanying drawings in detail. Referring to the drawings, wherein like reference characters designate like or corresponding parts throughout the several views. In the embodiments of the present invention, the publicly known functions and configurations that are judged to be able to make the purport of the present invention unnecessarily obscure will not be described.

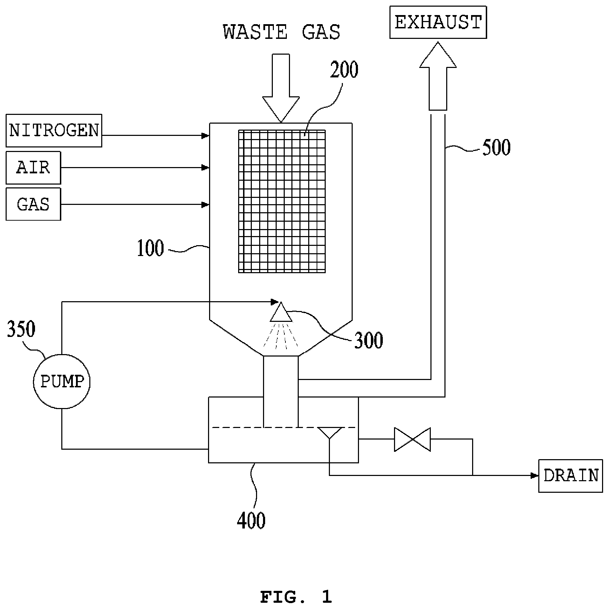

FIG. 1 is a view illustrating a structure of an electric heater type harm-removing apparatus according to an embodiment of the present invention. Referring to FIG. 1, the electric heater type harm-removing apparatus according to the embodiment of the present invention includes a reaction chamber 100, an electric heater structure 200, a water spray part 300, a precipitation part 400, and an exhaust part 500.

First, the reaction chamber 100 is supplied with waste gas such as perfluorocarbon compound (PFC) gas from an outside of the apparatus, and has an electric heater structure 200 installed therein. The electric heater structure 200 is heated by a power supplied from electrode units 150 and 235 included inside the reaction chamber 100 to transfer heat from the heater to the waste gas by a contact reaction between the waste gas and the heated electric heater structure 200, a convection process, and radiant heat, thereby performing a thermal decomposition of the waste gas.

Meanwhile, a lower part of the reaction chamber 100 is provided with the water spray part 300, that is, a precipitation water injection nozzle which is configured to receive precipitation water through a pump 350 and sprays the precipitation water to a lower space of the reaction chamber 100.

The precipitation water sprayed from the water spray part 300 captures aqueous particles generated by being thermally decomposed from the waste gas, and the aqueous particles dissolved in the precipitation water are introduced into the precipitation part 400 which is installed under the water spray part 300, along with the precipitation water.

Meanwhile, the precipitation water introduced into the precipitation part 400 is discharged to the outside along with the aqueous particles. In this case, as the aqueous particles generated by being thermally decomposed from the waste gas are separated, residual gas is formed in the reaction chamber, and discharged to the outside through the exhaust part 500.

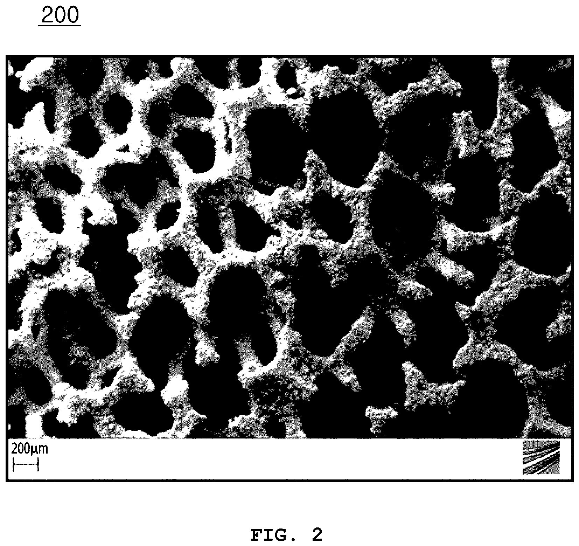

FIG. 2 is a photograph describing a configuration of the electric heater structure 200 included in the electric heater type harm-removing apparatus according to the embodiment of the present invention. As illustrated in FIG. 2, the electric heater structure 200 included in the electric heater type harm-removing apparatus according to the embodiment of the present invention is preferably manufactured as a porous metal structure.

As illustrated in FIG. 2, the porous metal structure has a structure capable of maximizing the contact area with the waste gas and may more activate the thermal decomposition of the waste gas.

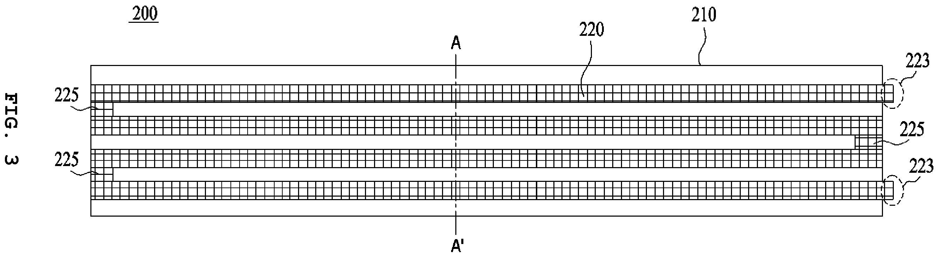

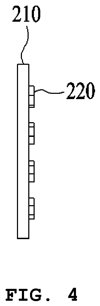

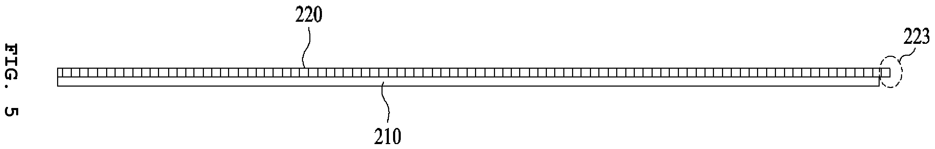

FIGS. 3 to 5 are views describing a modified structure of the electric heater structure 200 included in the electric heater type harm-removing apparatus according to the embodiment of the present invention. In detail, FIG. 3 is a front view describing the modified structure of the electric heater structure 200, FIG. 4 is a cross-sectional view taken on line A-A' and FIG. 5 is a lower side view of the structure illustrated in FIG. 3.

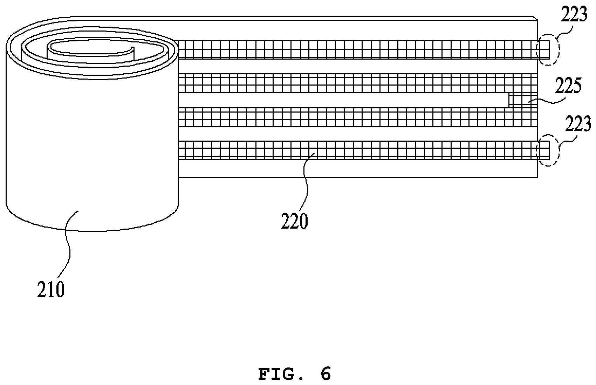

Meanwhile, FIG. 6 is a view illustrating a structural modification process during manufacturing the electric heater structure 200 of FIG. 3.

That is, as illustrated in FIGS. 3 and 4, when manufacturing the electric heater structure 200 according to the embodiment of the present invention, band-shaped porous metal heaters 220 are continuously disposed and attached to one surface of a rectangular insulating base layer 210, and then, as illustrated in FIG. 6, the insulating base layer 210 having the porous metal heaters 220 attached thereon is wound in a roll shape, to form the electric heater structure having a spiral structure.

For this, both of the insulating base layer 210 and the band-shaped porous metal heaters 220 may be made of a flexible material, and specifically, the insulating base layer 210 may be manufactured as a layer of a flexible ceramic material.

Meanwhile, it is necessary for each of the band-shaped porous metal heaters 220 attached on one surface of the insulating base layer 210 to be electrically connected to each other as a whole. Therefore, as illustrated in FIGS. 3, 5, and 6, the band-shaped porous metal heaters 220 are provided with external electrode connecting terminals 223 protruding from an end part of the insulating base layer 210, and the electric heater structure 200 formed in the spiral structure is supplied with power through the connecting terminals 223 with being installed within the reaction chamber 100.

To allow the band-shaped porous metal heaters 220 attached to one surface of the insulating base layer 210 to be electrically connected to each other as a whole, as illustrated in FIG. 3, it is preferable that a connecting part 225 which plays a role of a connecting heater is provided at the end part of the insulating base layer 210, so as to electrically connect the plurality of band-shaped porous metal heaters 220 arranged parallel to each other.

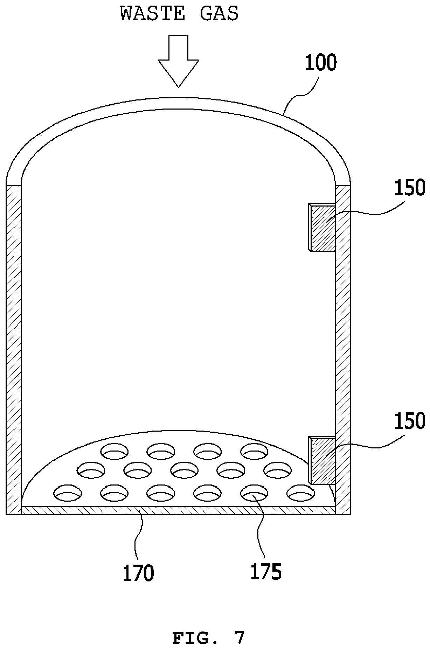

FIG. 7 is a view illustrating the structure of the reaction chamber into which the electric heater structure manufactured according to the method of FIG. 6 is inserted.

Referring to FIG. 7, an inner surface of the reaction chamber 100 is provided with the electrode parts 150 for supplying power, while being connected to the connecting terminals 223 of the electric heater structure 200.

Further, a bottom plate 170 of the reaction chamber 100 is provided with gas discharge holes 175, so as to discharge the waste gas, which is supplied into the reaction chamber 100 and thermally decomposed therein, to the outside.

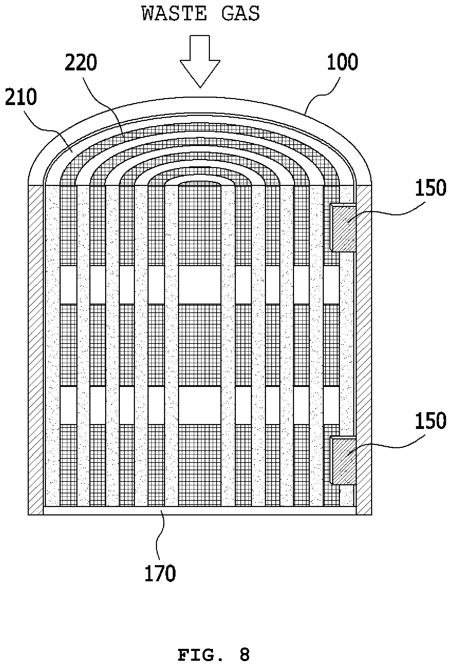

FIG. 8 is a view illustrating the state in which the electric heater structure manufactured according to the method of FIG. 6 is installed in the reaction chamber. As illustrated in FIG. 8, in the state in which the electric heater structure 200 having the spiral structure is installed in the reaction chamber 100, the waste gas supplied into the reaction chamber 100 is supplied and flowed through the electric heater structure 200 having the spiral structure, such that the waste gas may contact band-shaped porous metal heater 220 over an entire area thereof illustrated in FIG. 3.

As described above, the electric heater structure 200 manufactured in the spiral structure has a structure capable of maximizing the contact area between the metal heater and the waste gas to transfer heat from the heater to the waste gas within a rapid time with a uniform temperature distribution, thereby more activating the thermal decomposition of the waste gas.

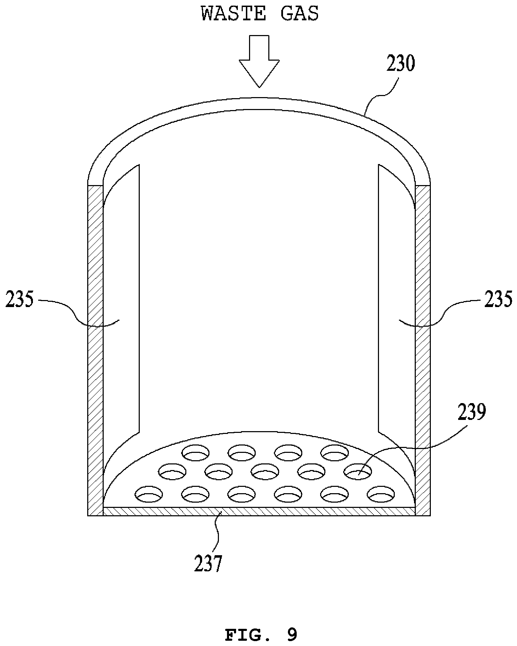

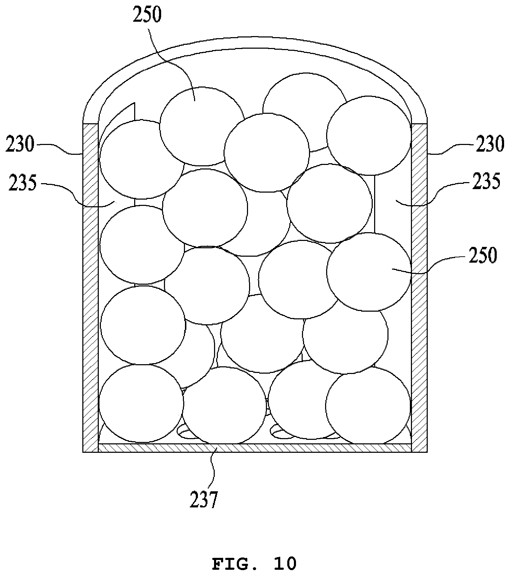

FIGS. 9 and 10 are views describing another modified structure of the electric heater structure 200 included in the electric heater type harm-removing apparatus according to the embodiment of the present invention. As illustrated in FIGS. 9 and 10, according to the embodiment of the present invention, an upper part of the electric heater structure 200 is provided with an injection port through which the waste gas may be ventilated and the inside thereof may also be manufactured using a cylindrical case 230 which is filled with a plurality of spherical metal balls 250.

In detail, an inner surface of the cylindrical case 230 is separately provided with the electrode parts 235, so that a current is supplied to the metal balls 250 contacting the inner surface of the cylindrical case 230 as illustrated in FIG. 9.

Therefore, the supplied to the metal balls 250 from the electrode parts 235 of the inner surface of the cylindrical case 230 may be continuously transferred to other adjacent metal balls 250 (FIG. 10) through a point contact therebetween. As a result, all the metal balls 250 filled in the inner surface of the cylindrical case 230 may be supplied with a current through a plurality of point contacts therebetween.

In the state in which the electric heater structure 200 having the structure as illustrated in FIG. 10 is installed inside the reaction chamber 100, the waste gas supplied into the reaction chamber 100 through the opened upper surfaces of the cylindrical case 230 contacts outer circumferential surfaces of the metal balls 250. In this case, the plurality of metal balls 250 are configured to have point contacts therebetween, and thereby the waste gas may contact the entire outer circumferential surface of the plurality of metal balls 250.

As described above, the electric heater structure 200 manufactured using the plurality of metal balls 250 configured to have the point contacts therebetween has a structure capable of maximizing the contact area between the surfaces of the metal balls 250 and the waste gas, so as to transfer heat from the heater to the waste gas within a rapid time with a uniform temperature distribution, and thereby more activating the thermal decomposition of the waste gas.

Further, the waste gas which is supplied into the cylindrical case 230 and reacts with the plurality of metal balls 250 is thermally decomposed, and then, discharged to the outside of the reaction chamber 100 through discharge holes 239 formed in a bottom plate 237 of the cylindrical case 230.

Meanwhile, as the reaction with the waste gas is continued, in the case of the corrosive waste gas, a volume of the metal balls 250 is gradually reduced due to a corrosive phenomenon of the surfaces of the metal balls, and therefore the contact area between the metal balls 250 and the waste gas may be reduced. In this case, in order to solve this problem, a manager additionally inserts the metal balls 250 into the cylindrical case 230, to maintain the entire volume of the metal balls with a constant level.

Meanwhile, according to the embodiments of the present invention, the cylindrical case 230 may be the reaction chamber 100 itself.

While the present invention has been described with reference to the preferred embodiments and modified examples, the present invention is not limited to the above-described specific embodiments and the modified examples, and it will be understood by those skilled in the related art that various modifications and variations may be made therein without departing from the scope of the present invention as defined by the appended claims, as well as these modifications and variations should not be understood separately from the technical spirit and prospect of the present invention.

In addition, the terminology used herein is for the purpose of describing particular embodiments only and is not intended to limit the present invention thereto. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements, and/or components, but do not preclude the presence or addition of one or more other features, integers, steps, operations, elements, components, and/or groups thereof.

### [Industrical Applicability]

The present invention can be applied to the harm-removing equipment, such that industrial applicability thereof may be recognized in the related industrial fields.

## Claims

1. An electric heater type harm-removing apparatus, comprising:
a reaction chamber 100 which has an electric heater structure 200 installed therein, and is configured to receive waste gas supplied from an outside thereof,
wherein the electric heater structure 200 includes a porous metal structure.

2. An electric heater type harm-removing apparatus, comprising:
a reaction chamber 100 which has an electric heater structure 200 installed therein, and is configured to receive waste gas supplied from an outside thereof,
wherein the electric heater structure 200 includes an insulating base layer 210, and a band-shaped porous metal heater 220 attached to one surface of the insulating base layer 210.

3. The electric heater type harm-removing apparatus according to claim 2, wherein the insulating base layer 210 is formed in a spiral structure.

4. The electric heater type harm-removing apparatus according to claim 3, wherein the porous metal heater is exposed to the waste gas supplied and flowed through the insulating base layer 210 having the spiral structure.

5. An electric heater type harm-removing apparatus, comprising:
a reaction chamber 100 which has an electric heater structure 200 installed therein, and is configured to receive waste gas supplied from an outside thereof,
wherein the electric heater structure 200 includes a cylindrical case 230 of which the upper part is opened, and a plurality of metal balls 250 filled in the cylindrical case 230.

6. An electric heater structure 200 installed inside an electric heater type harm-removing apparatus, comprising:
an insulating base layer 210; and
a band-shaped porous metal heater 220 which is attached to one surface of the insulating base layer 210.

7. The electric heater structure according to claim 6, wherein the insulating base layer 210 is formed in a spiral structure.

8. The electric heater structure according to claim 7, wherein the porous metal heater is exposed to the waste gas supplied and flowed through the insulating base layer 210 having the spiral structure.

9. An electric heater structure installed inside an electric heater type harm-removing apparatus, comprising:
a cylindrical case 230 which is configured to receive waste gas from an opened upper part thereof; and
a plurality of metal balls 250 which are filled in the cylindrical case 230.
